# EUROPEAN PATENT SPECIFICATION

(11) **EP 2 151 050 B1**
(45) Date of publication and mention of the grant of the patent: **17.10.2012**
(21) Application number: 08749728.5
(22) Date of filing: 25.04.2008
(51) Int. Cl.: H03H 11/16

(54) **CASCADED PHASE-SHIFTER**
KASKADIERTER PHASENSCHIEBER
DÉPHASEUR EN CASCADE

(30) Priority: 26.04.2007 DE 102007019745; 26.12.2007 US 16669
(43) Date of publication of application: 10.02.2010
(73) Proprietor: TEXAS INSTRUMENTS DEUTSCHLAND GMBH, 85356 Freising (DE)
(72) Inventor: BOCK, Andreas, 30900 Wedemark (DE)
(74) Representative: Holt, Michael
(86) International application number: PCT/EP2008/055063
(87) International publication number: WO 2008/132160

(56) References cited:
- JP-A- 52 123 843
- MONTEMAYOR R ET AL: "A self-calibrating 900-MHz CMOS image-reject receiver" SOLID-STATE CIRCUITS CONFERENCE, 2000. ESSCIRC '00. PROCEEDINGS OF THE 26RD EUROPEAN STOCKHOLM, SWEDEN 19-21 SEPT. 2000, PISCATAWAY, NJ, USA,IEEE, 19 September 2000 (2000-09-19), pages 320-323, XP010823631 ISBN: 978-2-86332-249-9
- VASANTH KAKANI ET AL: "A 3.5GHz Low Power Programmable Transversal Filter RFIC Implemented in 47GHz SiGe Technology" BIPOLAR/BICMOS CIRCUITS AND TECHNOLOGY MEETING, 2006, IEEE, PI, 1 October 2006 (2006-10-01), pages 1-4, XP031047290 ISBN: 978-1-4244-0458-2

## Description

The present invention relates to a phase-shifter, more specifically to a phase-shifter having multiple delay stages.

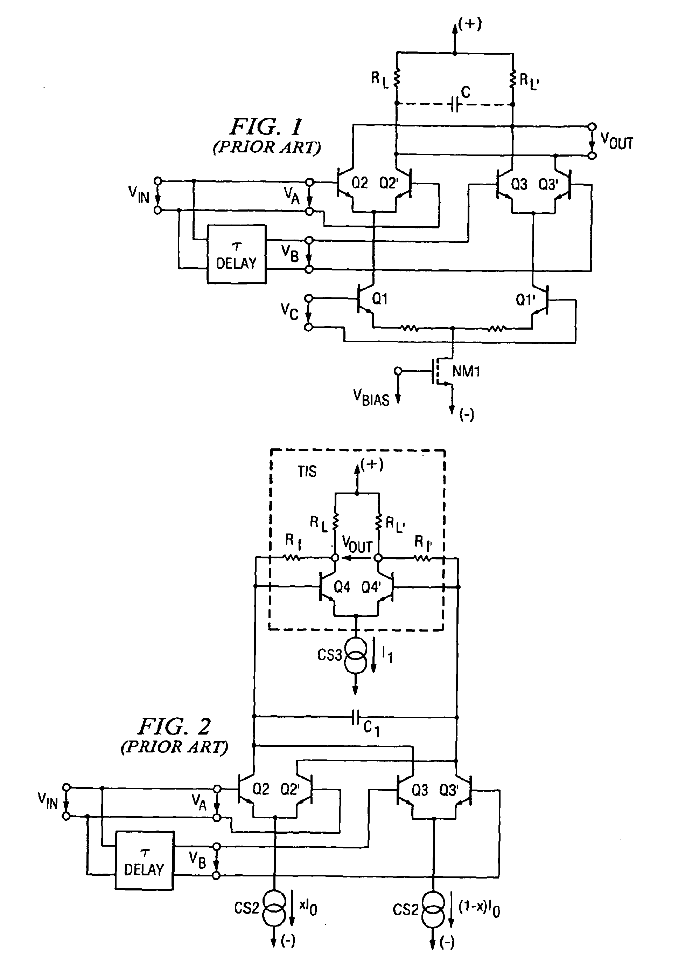

In broad band communication systems, phase shifters with a wide shifting and frequency range are in high demand. For example, such phase shifters are required in the delay adjustment of clock signals in clock recovery systems, channel deskewing and wave-shaping circuitry, where signals are superimposed with their delayed counterpart to generate an output signal with the desired wave shape. A conventional solution capable of a π/2 phase-shifting range, is shown in Fig. 1 of the article by Dawson and Rogerson, "An Undersea Fiber-Optic Regenerator Using an Integral-Substrate Package and Flip-Chip SAW Mounting", Journal of Light Wave Technology, Vol. LT-2, No. 6, Dec. 1984. For the conventional solution, a maximum phase shift of 2π/3 has been disclosed. However, a reduced phase shift of π/2, rather than 2π/3, turned out to be more reasonable and proposals were made to extend the range subsequently by means of frequency dividers and frequency doublers. This approach is disclosed in "The Continuously Variable GHz Phase-Shifter IC Covering More Than One Frequency Decade", IEEE Journal of Solid-State Circuits, Vol. 27, No. 6, June 1992, by Lothar Schmidt and Hans-Martin Rein. Improvements of the basic phase-shifted stage use a Cherry-Hooper type circuitry and low pass filtering as described in "The Design of Wide-Band-Transistor Feedback Amplifier Mounting" by E.M. Cherry, D.E. Hooper. A modified phase shifter circuitry using the Cherry-Hooper load is shown in Figure 2. The emitter degenerated transistor pair Q1, Q1' for current steering as shown in Figure 1 is not shown in Figure 2. The basic idea of a phase-shifter consists in superimposing a signal with its delayed (shifted in phase) counterpart. Referring to Figure 1, applying a sufficiently high positive voltage V_{C} to the lower differential transistors will mainly or completely steer the tail current to the upper left differential pair, which is connected to the not delayed input V_{A}. A setting V_{C} = 0 will create an output signal superimposed by both the not delayed input V_{A} and the delayed signal V_{B}. A high negative V_{C} voltage will finally switch the tail current completely to the upper right differential pair connected to the delayed input V_{B}. The superimposed rectangular input signals may lead to severe signal distortion. A low signal distortion can be achieved by feeding the mixer stage, i.e. the upper two differential switches with joint load, with a sinusoidal input signal (low pass filtering) or by filtering the distorted output current of the mixer prior to feeding it to a transimpedance stage (TIS). Both approaches to filter the signal in order to reduce the signal distortion have the drawback of an increased minimum delay (phase shift). Another drawback of the prior art solution results in the manner in which the input signal V_{B} is delayed. The simple low pass filter

(RC) or a transmission line will significantly attenuate the high frequency components of the signal and change its shape from rectangular to a more or less sinusoidal one (band width limited signal) and also reduce the amplitude of V_{B}. Superimposing two signals with different shape and amplitude can result in unwanted additional distortion.

It is an object of the present invention to provide a phase shifter with an adjustable phase of the output signal having lower distortion, lower minimum delay time and high bandwidth.

Accordingly, a phase shifter is provided, which includes at least two cascaded delay stages each comprising a first differential pair of bipolar transistors and a second differential pair of bipolar transistors. The bases of the first differential pair of bipolar transistors serve as input nodes for the delay stage. The emitters of the first differential pair are coupled to a first current source and the collectors of the first differential pair of bipolar transistors are coupled to respective loads to provide differential output nodes of the delay stage. The bases of the second differential pair of bipolar transistors are coupled to the respective output nodes of the first differential pair and the emitters of the second differential pair are coupled to a variable current source for selectively adjusting the current through the second differential pair. The inputs of each following delay stage are coupled to the output nodes of a preceding delay stage, and a common load stage is coupled to the collector nodes of the second differential pairs of bipolar transistors of all delay stages to provide a differential output signal, wherein the amount of phase shift of the output signal is adjusted by adjusting the current through the second differential pairs by the variable current sources.

So, the first aspect of the present invention is based on the idea of using cascaded stages to generate the required delay (phase shift) instead of using a delay line coupled between the inputs of two stages. The delay stages according to the present invention include respective second pairs of transistors, which are all coupled to the same load stage (transimpedance stage). The load stage superimposes the signals of the delay stages. The second differential pair of each delay stage contributes an output current, which is fed to the transimpedance stage. The amount of output current per delay stage defines how much the respective delay stage contributes to the output signal. A higher current contribution of a delay stage, which is positioned later in the cascade of delay stages, results in a greater phase shift (delay) of the output signal with respect to the input signal fed to the first delay stage. A higher contribution of an earlier delay stage in the chain results in less phase shift (delay).

According to an aspect of the invention, The phase shifter may include controlling means to control the delay stages such that only two adjacent delay stages may be used to define the phase shift, i.e. the second differential pairs of only two adjacent delay stages may be switched on, such that the currents contribute to the output signal, while the other second differential pairs are switched off.

The bases of the second differential pair of bipolar transistors of each delay stage are either directly connected to respective output nodes of the first differential pair of the same delay stage, or the bases of the second differential pair of bipolar transistors of each delay stage are coupled through a level shifter to respective output nodes of a preceding delay stage. Further, the delay stages may be connected directly to each other or, if necessary, by use of level shifters in order to adapt the voltage levels of the output signals to the input signals.

If the cascaded delay stages are basically directly connected to each other and the second differential pairs (i.e. the bases of the transistors) within the delay stages are also connected directly to the output nodes of the first differential pairs, then the phase shifter profits from translinear coupling and operates in a current mode. According to this aspect of the invention, there is no need to use bulky (voltage) level shifters between consecutive delay stages as the behavior of the circuit becomes invariably a consequence of current ratios. The input signals (being typically a voltage) may only be transferred once into the current domain, e.g. in the first input stage. The delay stages are inherently linear. Due to the high bandwidth of the current mode connected stages, the phase shifting range covered by two stages is smaller than in prior art (voltage mode) solutions. However, due to the pre-distortion characteristic of the current mode connection at the same time the signal distortion is lower than for the conventional solutions. Therefore, additional filtering to suppress distortion is not necessary. In particular, the RC-filters for preventing distortion are not necessary any more and can be omitted.

According to another aspect of the invention, the cascaded delay stages may be coupled to each other via a resistor, which is preferably connected between the output node of a preceding delay stage and the base of a transistor of the first differential pair of a subsequent delay stage, such that the resistor and, for example, a parasitic capacitance of the subsequent delay stage constitute an RC network with a low pass filter characteristic. The resistors between the delay stages should be chosen with great care not to introduce additional distortion, i.e. not to impair the equalization effect of the current mode coupling. Also, the transimpedance (load) stage, which is coupled as a common load to the second differential pairs of all delay stages may preferably be implemented as a Cherry-Hooper-style load.

In order to achieve a broader range for the phase shift (delay), a fixed delay stage (or multiple fixed delay stages) having only a single differential pair of transistors (i.e. the first differential pair) can be coupled between two adjacent delay stages. As the minimum delay of a single delay stage is smaller than the minimum delay of a prior art solution, enlarging the range of possible phase shifts is useful.

According to an aspect of the present invention, a method of providing a phase shift with a phase shifter which is implemented in accordance with the aspects set out here above. The method includes selectively controlling the variable currents sources of a plurality of delay stages, such that only the second differential pairs of bipolar transistors of consecutive pairs of delay stages are activated, thereby continuously determining the delay of the phase shifter over the whole shifting range. Accordingly, only two consecutive (either adjacent or separated by a fixed delay stage) delay stages receive sufficient current through the variable current source to contribute to the delay in the superimposed output signal. The remaining second pairs of delay stages are basically idle (i.e. switched off) and do not contribute to the delay. This approach allows to save power and to precisely adjust the phase shift. In order to save more power, it is possible to switch off even the first pairs of those delay stage, which follow the last delay stage having an activated (used) second differential pair. At least the first differential pairs of the delay stages preceding the pair of delay stages being used for the fine tuning of the phase shift (i.e. having activated second differential pairs) have to be activated.

More details of the present invention will ensue from the description of the preferred embodiments here below by reference to the accompanying drawings, wherein
- Figure 1 shows a simplified schematic of a phase-shifter stage according to the prior art,
- Figure 2 shows a simplified schematic of a modified phase shifter stage according to the prior art,
- Figure 3 shows a simplified schematic of another modified phase shifter according to a first aspect of the present invention,
- Figure 4 shows two examples for a current mode connected phase shifter according to a second aspect of the present invention,
- Figure 5 shows a simplified schematic of an embodiment of a phase shifter according to a third aspect of the present invention, and
- Figure 6 shows a simplified schematic of another embodiment of a phase shifter according to a fourth aspect of the present invention.

Figure 1 shows a simplified schematic of a prior art solution of a phase shifter. Accordingly, the output signal V_{OUT} is a delayed (phase shifted) version of the input signal V_{IN}. The input voltage V_{IN} is coupled to the differential pair Q2, Q2' and a delayed version V_{B} of the input voltage V_{IN} is coupled to the second differential pair Q3, Q3'. As Q3, Q3' receives the delayed version V_{B} of the input signal V_{IN}, the amount of phase shift can be controlled by the control voltage V_{C}. V_{C} is coupled to the differential pair Q1, Q1'. A load stage consisting of RL, RL' is commonly coupled to the collectors of the differential pairs Q2, Q2' and Q3, Q3'. A current source is implemented by NMOS transistor NM1 having a bias voltage to sink a constant current through the differential pair Q1, Q1'. A high positive voltage V_{C} opens transistor Q1 and steers all or the major part of the current through differential pair Q2, Q2'. Accordingly, the output voltage V_{OUT} is basically in phase with the input voltage V_{IN} having a minimum delay due to the inherent delays of the components. A negative voltage V_{C} opens Q1' and closes transistor Q1 such that the differential pair Q3, Q3' and the output voltage V_{OUT} is dominated by V_{B}.

Figure 2 shows a simplified schematic of a conventional phase shifter with a Cherry-Hooper-style transimpedance stage coupled as a common load to the delay stages. However, superimposing rectangular input signals in the solution of Figure 2 results in considerable distortion. Low signal distortion can be achieved by feeding the differential pairs Q2, Q2' and Q3, Q3' with a sinusoidal input signal. This requires low pass filtering of the rectangular input signal. Another approach is to filter the distorted output currents of Q2, Q2' and Q3, Q3' (mixer-stage) prior to feeding it to the transimpendance stage TIS. However, filtering the signals in order to reduce the signal distortion has the drawback of an increased minimum delay (phase shift).

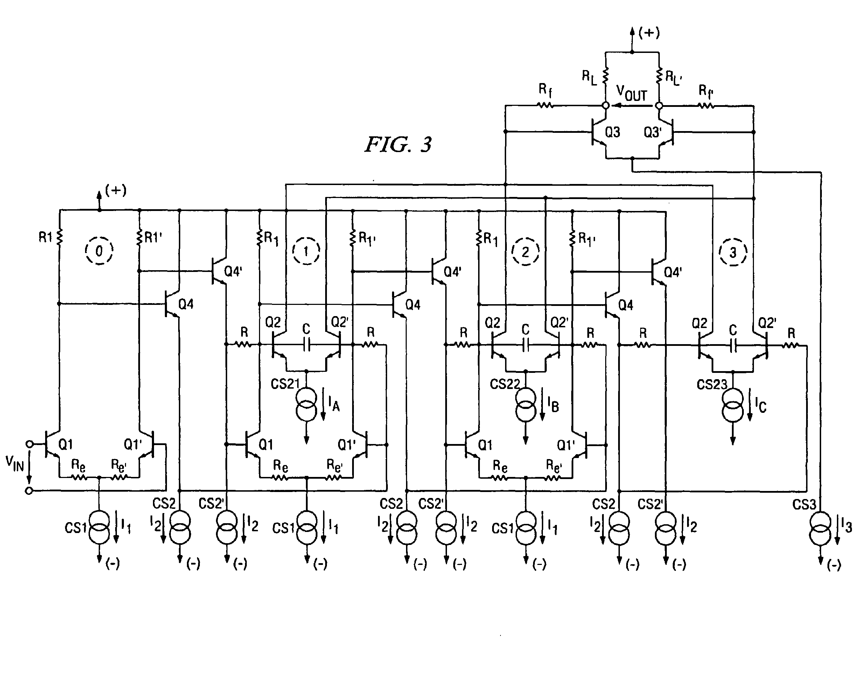

Figure 3 shows a simplified schematic of a three-stage solution of a phase shifter according to a first aspect of the present invention. Instead of two stages coupled by a delay line, there are three consecutive delay stages indicated by a number in a dotted circle (1, 2 and 3), and an input stage indicated by 0. The transadmittance parts of the mixer consist of differential pairs Q2, Q2' whereas the delay stages have differential pairs Q1, Q1' and resistors Re, Re'. The current sources CS1, CS2, CS2' as well as CS3 are constant current sources. Variable current sources are CS21, CS22 and CS23 providing currents I_{A}, I_{B} and I_{C}. The transimpedance stage TIS consists of load resistors RL, RL' and Rf, Rf. Further, there is a differential pair Q3, Q3' in the transimpedance stage TIS. The mixer stages are coupled via resistors R and a capacitance C to the delay stages in order to provide a low pass filtering. For I_{A} = I₀, the minimum delay (phase shift) is achieved. For low delay settings (phase shift) the current is steered between stage 1 and stage 2 (I_{A} = [1-x]*I₀ and I_{B} = x*I₀ with x varying from 0 to 1; I_{C} = 0) while I_{C} is turned off. For x =1 and greater, the delays are adjusted by distributing the current between stage 2 and stage 3 while the tail current I_{A} is kept close to zero (I_{B} = [1-x]*I₀ and I_{C} = x* I₀ with x varying from 0 to 1; I_{A} = 0). Only the tail current of the differential pairs marked with a highlighted number (dotted circle) are varied or turned off. All other tail currents have fixed values (e.g. I₁). The cascaded stage design based on a common phase shifter as depicted in Figure 3 has two major drawbacks: It requires power-consuming level shifters Q4, Q4' (emitter follower in the example) and the filter increases the minimum adjustable delay (phase shift).

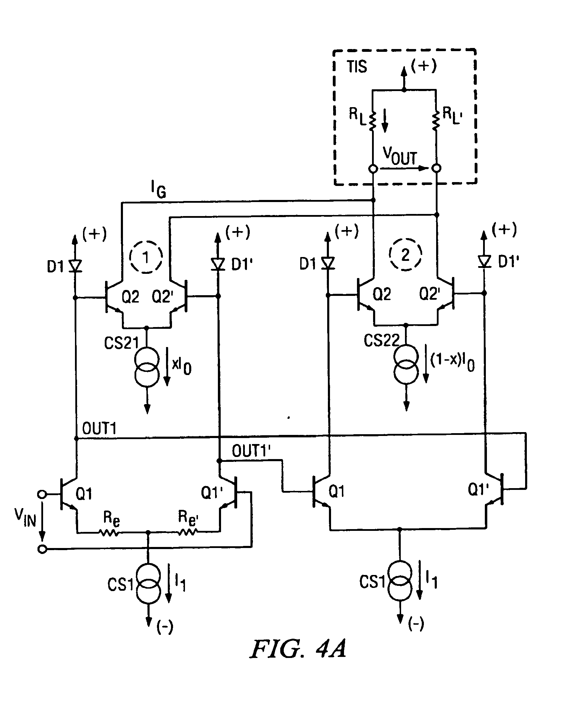

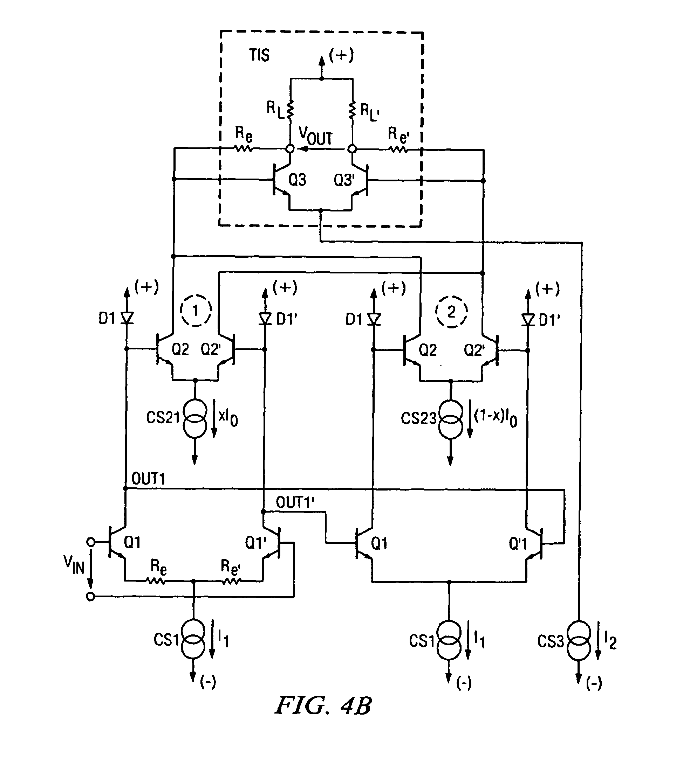

Figure 4 shows two different embodiments of a phase shifter according to the present invention. Figure 4 (a) has two delay stages 1 and 2 indicated by numbers in circles. Each delay stage consists of a differential pair Q1, Q1', a current source CS1 coupled to the differential pair Q1, Q1' and diode load elements D1, D1'. A second differential pair Q2, Q2' is coupled to the collectors of the first differential pair Q1, Q1'. A variable current source CS21, CS22 is coupled to the respective differential pair Q2, Q2'.The differential pairs Q2, Q2' may be considered as the mixer stage or the transadmittance stage of the common load. In Figure 4 (a) the load coupled to all mixer stages consists of two resistors RL, RL'. By adjusting the currents xI₀ and (1-x) I₀ of the current source CS21 and CS22 the phase shift of the output signal V_{OUT} is shifted between a minimum and a maximum value. The resistors Re, Re' coupled to the emitters of the first differential pair Q1, Q1' of the input stage serve to linearise the input signal and to reduce distortion of the superimposed input signals. The amplification of the input stage is reduced, the bandwidth increased and the delay of the input stage is also reduced by using the resistors Re, Re'. The second delay stage operates in linear mode due to the transistors in common base connection. Directly connecting the bases of the first differential pair of bipolar transistors Q1, Q1' of the second delay stage 2 to the output nodes OUT1, OUT1' of the first delay stage 1 and directly connecting the bases of the bases of the bipolar transistors Q2, Q2' of the second differential pairs of each delay stage 1,2 provides translinear coupling, such that the delay stages operate in a current mode. Accordingly, the delay stages are inherently linear and RC-filtering to suppress distortions is not necessary. The bulky and power consuming level shifters (Q4, Q4' in Figure 3) of the circuit shown in Figure 3 can be omitted, too.

Figure 4 (b) shows a simplified schematic of a second embodiment of the present invention. The delay stages 1, 2 have basically the same components as shown in Figure 4 (a). Also, the basic functionality is the same. The embodiment of Figure 4 (b) has a transimpedance stage that is implemented in a Cherry-Hooper style. The common load coupled to all delay stages consists of a differential pair Q3, Q3', the load resistors RL, RL' and resistors Re, Re'.

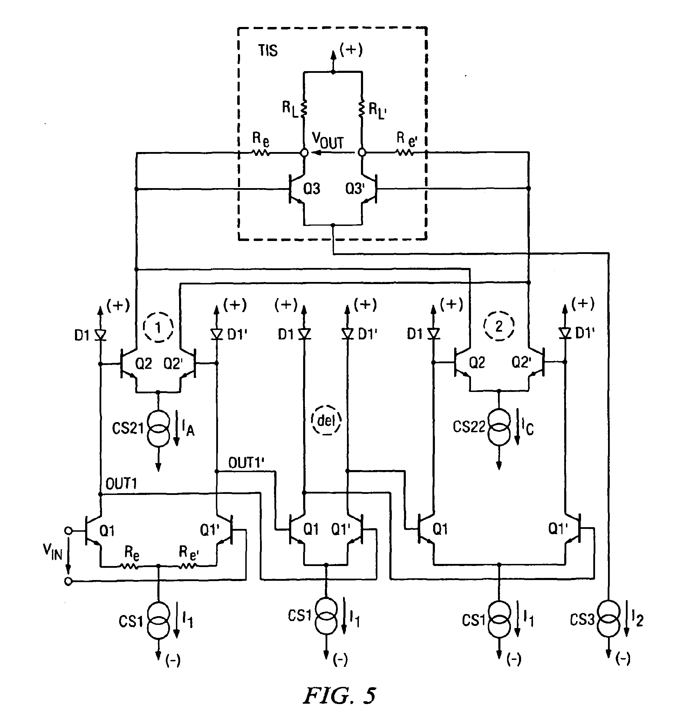

Figure 5 shows a simplified schematic of another embodiment of the present invention. In order to avoid a high count of cascaded stages or inputs for the phase shifter, additional delay stages may be intercepted as depicted in Figure 5. The delay stage indicated by del in a dotted circle is used to introduce an additional delay between the delay stages 1 and 2. According to an aspect of the present invention, it is suggested to cascade delay stages instead of using RC-delay elements or delay lines between the delay stages.

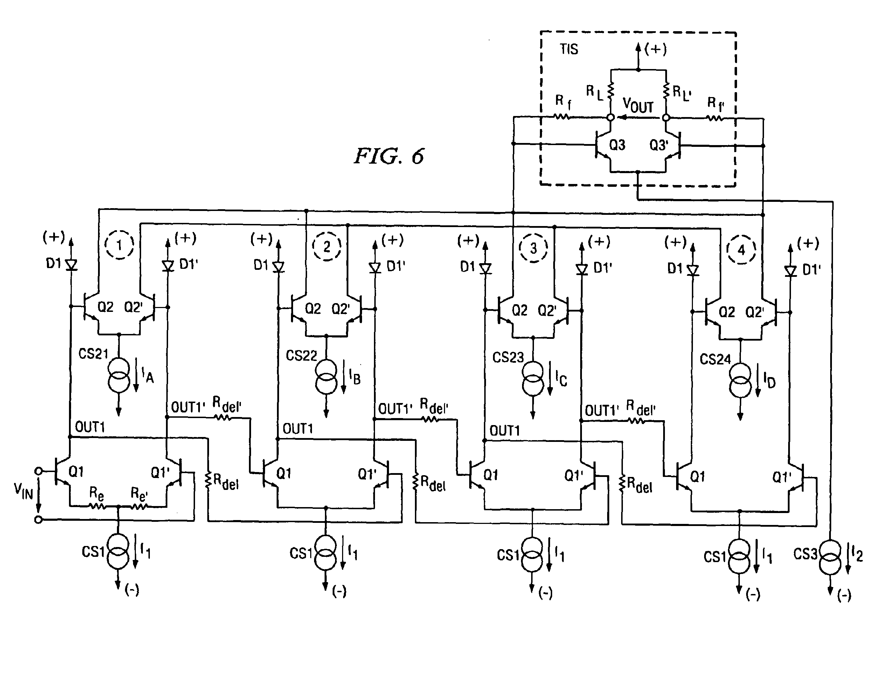

Figure 6 shows a simplified schematic of an embodiment according to the present invention. Accordingly, four cascaded delay stages 1, 2, 3 and 4 are provided. The differential pairs Q1, Q1' and Q2, Q2' of each delay stage are coupled to each other in a current mode manner. The current sources CS1 and CS3 provide a constant current, whereas the current sources CS21, CS22, CS23 and CS24 are variable current sources providing the currents I_{A}, I_{B}, I_{C} and I_{D}, respectively. The respective output currents of the differential pairs Q2, Q2' of each delay stage (the mixer stage) are combined in the transimpedance stage TIS being implemented in a Cherry-Hooper style. By coupling the outputs of each preceding delay stage to the subsequent delay stage via an additional resistor R_{del}, R_{del'}, an additional delay can be introduced. However, the resistors should be dimensioned with great care not to produce additional distortion. According to one possible configuration, only two adjacent delay stages may be used to adjust the phase shift. Accordingly, for small phase shifts, only the currents I_{A}, and I_{B}, may be tuned and I_{C} and I_{D} may be switched off. For greater phase shifts, only I_{B}, and I_{C} may be adjusted and I_{D} and I_{A} may be switched off. Finally, for maximum phase shift, I_{C} and I_{D} may be used and I_{A}, and I_{B}, may be turned off. This procedure of controlling the four currents I_{A}, I_{B}, I_{C} and I_{D} in order to provide only a pair-wise contribution of the delay stages to the total phase shift can be implemented by a specific control stage. If the phase shift or delay is defined by the delay stage 2 and 3 (currents I_{B}, I_{C}), the first differential pair Q1, Q1' of the first delay stage 1 must be correctly biased, i.e. switched on, as the delay of the first stage contributes to the total delay. Yet, the delay stage 4 may be switched off or put in a power-down modus, as this delay stage does not contribute to the total delay.

## Claims

1. A phase shifter comprising:
at least two cascaded delay stages (1, 2) each comprising a first differential pair of bipolar transistors (Q1, Q1') and a second differential pair of bipolar transistors (Q2, Q2'),
the bases of the first differential pair of bipolar transistors (Q1, Q1') serving as input nodes for the delay stage, the emitters of the first differential pair being coupled to a first current source (CS1) and the collectors of the first differential pair of bipolar transistors (Q1, Q1') being coupled to respective loads (D1, D1'; R1, R1') to provide differential output nodes (OUT1, OUT1') of the delay stage,
the bases of the second differential pair of bipolar transistors (Q2, Q2') being coupled to respective output nodes of a first differential pair (Q1, Q1') of a delay stage and the emitters of the second differential pair of bipolar transistors (Q2, Q2') being coupled to a variable current source (CS21, CS22,...) for selectively adjusting the current (IA, IB,...) through the second differential pair (Q2, Q2'),
the input nodes of each following delay stage (2,..) are coupled to the output nodes of a preceding delay stage, and
a common load stage coupled to the collectors of the second differential pairs of bipolar transistors (Q2, Q2') of all delay stages to provide a differential output signal, wherein the amount of phase shift of the output signal is adjusted by adjusting the current through the variable current sources (CS21, CS22,...).

2. The phase shifter according to claim 1, wherein the bases of the second differential pair of bipolar transistors (Q2, Q2') of each delay stage are directly connected to respective output nodes of the first differential pair (Q1, Q1') of the same delay stage.

3. The phase shifter according to claim 1, wherein the bases of the second differential pair of bipolar transistors (Q2, Q2') of each delay stage are coupled through a level shifter (Q4, Q4') to respective output nodes of a preceding delay stage.

4. The phase shifter according to claim 1 or 2, wherein the respective bases of the first differential pair of a following delay stage are directly connected to the output nodes of a preceding delay stage.

5. The phase shifter according to claim 3, wherein the respective bases of the first differential pair of a subsequent delay stage are coupled through the level shifter (Q4, Q4') to the output nodes of a preceding delay stage.

6. The phase shifter according to one of the previous claims, comprising multiple cascaded delay stages and means for selectively controlling the variable current sources (CS21, CS22,...) of the plurality of delay stages, such that only second differential pairs of bipolar transistors (Q2, Q2') of consecutive pairs of delay stages are switched on.

7. The phase shifter according to claim 1 or 2, wherein a resistor is coupled between an output node of a preceding delay stage and the base of a transistor of the first differential pair of a subsequent delay stage, such that the resistor and a parasitic capacitance of the subsequent delay stage constitute an RC network with a low pass filter characteristic.

8. The phase shifter of one of the preceding claims, wherein the common load stage is a Cherry-Hooper-style load.

9. The phase shifter of one of the preceding claims, wherein a fixed delay stage having only a single differential pair of transistors is coupled between two adjacent delay stages.

10. A method of operating a phase shifter according to one of the previous claims, the method comprising selectively controlling the variable currents sources of a plurality of delay stages, such that only adjacent pairs of delay stages are activated, thereby continuously determining the delay of the phase shifter over the whole shifting range.

## Patentansprüche

1. Ein Phasenschieber bestehend aus:
mindestens zwei kaskadierten Verzögerungsstufen (1, 2), jede Stufe bestehend aus einem ersten differentiellen bipolaren Transistorpaar (Q1, Q1') und einem zweiten differentiellen bipolaren Transistorpaar (Q2, Q2').
den Füßen des ersten differentiellen bipolaren Transistorpaars (Q1, Q1') dienen als Eingangsknoten für die Verzögerungsstufe, die Emittern des ersten differentiellen Paars werden zu einer ersten Stromquelle (CS1) gekoppelt und die Kollektoren des ersten differentiellen bipolaren Transistorpaars (Q1, Q1') werden zu jeweiligen Ladungen (D1, D1'; R1, R1') gekoppelt, um differentiellen Ausgangsknoten (OUT1, OUT1') der Verzögerungsstufe zu liefern,
den Füßen des zweiten differentiellen bipolaren Transistorpaars (Q2, Q2') seiend zu den jeweiligen Ausgangsknoten eines ersten differentiellen Paars(Q1, Q1') einer Verzögerungsstufe gekoppelt, und die Emittern des zweiten differentiellen bipolaren Transistorpaars (Q2, Q2') seiend zu einer regelbaren Stromquelle (CS21, CS22,...) gekoppelt, um den Strom (IA,IB,...)selektiv durch das zweite differentielle Paar (Q2, Q2') zu steuern,
den Eingangsknoten von jeder folgenden Verzögerungsstufe (2,...) sind zu den Ausgangsknoten einer vorhergehenden Verzögerungsstufe gekoppelt, und
einer gemeinsamen Ladungsstufe werden zu den Kollektoren des zweiten differentiellen bipolaren Transistorpaars (Q2, Q2') von allen Verzögerungsstufen gekoppelt, um ein differentielles Ausgangssignal zu liefern, wobei das Phasenshiftniveau des Ausgangssignals durch die Steuerung des Stroms durch die regelbaren Stromquellen (CS21, CS22,...) gesteuert wird.

2. Der Phasenschieber nach Anspruch 1, wobei die Füße des zweiten differentiellen bipolaren Transistorpaars (Q2, Q2') jeder Verzögerungsstufe direkt zu den jeweiligen Ausgangsknoten des ersten differentiellen Paars (Q1, Q1') der gleichen Verzögerungsstufe verbundet werden.

3. Der Phasenschieber nach Anspruch 1, wobei die Füße des zweiten differentiellen bipolaren Transistorpaars (Q2, Q2') jeder Verzögerungsstufe durch einen Pegelschieber (Q4, Q4') zu den jeweiligen Ausgangsknoten einer vorhergehenden Verzögerungsstufe gekoppelt werden.

4. Der Phasenschieber nach Ansprüchen 1 oder 2, wobei die jeweiligen Füße des ersten differentiellen Paars einer folgenden Verzögerungsstufe direkt zu den Ausgangsknoten einer vorhergehenden Verzögerungsstufe verbundet werden.

5. Der Phasenschieber nach Anspruch 3, wobei die jeweiligen Füße des ersten differentiellen Paars einer folgenden Verzögerungsstufe durch den Pegelschieber (Q4, Q4') zu den Ausgangsknoten einer vorhergehenden Verzögerungsstufe gekoppelt werden.

6. Der Phasenschieber nach allen vorhergehenden Ansprüchen, bestehend aus mehreren kaskadierten Verzögerungsstufen und dem Mittel, um die regelbaren Stromquellen (CS21, CS22,...) der Vielzahl von Verzögerungsstufen selektiv zu steuern, damit nur die zweiten differentiellen bipolaren Transistorpaare (Q2, Q2') der hintereinanderen Paare von Verzögerungsstufen eingeschaltet werden.

7. Der Phasenschieber nach Ansprüchen 1 oder 2, wobei ein Widerstand zwischen einem Ausgangsknoten einer vorhergehenden Verzögerungsstufe und dem Fuß eines Transistors des ersten differentiellen Paars einer folgenden Verzögerungsstufe gekoppelt wird, damit der Widerstand und eine Parasitärkapazität der folgenden Verzögerungsstufe ein RC-Netzwerk mit einer Tiefpassfiltereigenshaft darstellen.

8. Der Phasenschieber nach allen vorhergehenden Ansprüchen, wobei die gemeinsame Ladungsstufe eine Cherry-Hooper-Style-Ladung ist.

9. Der Phasenschieber nach allen vorhergehenden Ansprüchen, wobei eine feste Verzögerungsstufe mit nur einem differentiellen Transistorpaar zwischen zwei anliegenden Verzögerungsstufen gekoppelt wird.

10. Ein Verfahren für den Betrieb eines Phasenschiebers nach einem der vorhergehenden Ansprüchen, das Verfahren bestehend aus der selektiven Steuerung der regelbaren Stromquellen einer Vielzahl von Verzögerungsstufen, damit nur die anliegenden Paare von Verzögerungsstufen aktiviert werden, dadurch wird die Verzögerung des Phasenschiebers auf dem ganzen Schiebungsbereich ständig bestimmt.

## Revendications

1. Un déphaseur comprenant:
au moins deux étages de retard en cascade (1, 2) chacune comprenant une première paire différentielle de transistors bipolaires (Q1, Q1') et une deuxième paire différentielle de transistors bipolaires (Q2, Q2'),
les bases de la première paire différentielle de transistors bipolaires (Q1, Q1') servent comme les noeuds d'entrée pour l'étage de retard, les émetteurs de la première paire différentielle étant couplés à une première source de courant (CS1) et les collecteurs de la première paire différentielle de transistors bipolaires (Q1, Q1') étant couplés aux charges respectifs (D1, D1' ; R1, R1') pour fournir des noeuds de sortie différentiel (OUT1, OUT1') de l'étage de retard,
les bases de la deuxième paire différentielle de transistors bipolaires (Q2, Q2') étant couplées aux noeuds de sortie respectifs de la première paire différentielle (Q1, Q1') d'une étage de retard et les émetteurs de la deuxième paire différentielle de transistors bipolaires (Q2, Q2') étant couplés à une source de courant variable (CS21, CS22,...) pour régler sélectivement le courant (IA, IB,...) par la deuxième paire différentielle (Q2, Q2'),
les noeuds d'entrée de chaque étage de retard suivante (2,...) sont couplés aux noeuds de sortie d'une étage de retard précédente, et
une étage de chargement commune couplée aux collecteurs des deuxièmes paires différentielles de transistors bipolaires (Q2, Q2') de toutes étages de retard pour fournir un signal de sortie différentiel, où le niveau de déplacement de phase du signal de sortie est réglé en réglant le courant par les sources de courant variables (CS21, CS22, ...).

2. Le déphaseur selon la revendication 1, où les bases de la deuxième paire différentielle de transistors bipolaires (Q2, Q2') de chaque étage de retard sont directement branchées aux noeuds de sortie respectifs de la première paire différentielle (Q1, Q1') de la même étage de retard.

3. Le déphaseur selon la revendication 1, où les bases de la deuxième paire différentielle de transistors bipolaires (Q2, Q2') de chaque étage de retard sont couplées par un décalage de niveau (Q4, Q4') aux noeuds de sortie respectifs d'une étage de retard précédente.

4. Le déphaseur selon les revendications 1 ou 2, où les bases respectives de la première paire différentielle d'une étage de retard suivante sont directement branchées aux noeuds de sortie d'une étage de retard précédente.

5. Le déphaseur selon la revendication 3, où les bases respectives de la première paire différentielle d'une étage de retard suivante sont couplées par le décalage de niveau (Q4, Q4') aux noeuds de sortie d'une étage de retard précédente.

6. Le déphaseur selon des revendications précédentes, comprenant les étages de retard en cascade multiples et les moyens de régler sélectivement les sources de courant variables (CS21, CS22, ...) de la pluralité d'étages de retard, de façon que seulement les deuxièmes paires différentielles de transistors bipolaires (Q2, Q2') des paires consécutives des étages de retard sont mises en marche.

7. Le déphaseur selon les revendications 1 ou 2, où une résistance est couplée entre un noeud de sortie d'une étage de retard précédente et la base d'un transistor de la première paire différentielle d'une étage de retard subséquente, de façon que la résistance et la capacitance parasite de l'étage de retard subséquente constitue un circuit résistance-condensateur avec une caractéristique de filtre passe-bas.

8. Le déphaseur selon les revendications précédentes, où l'étage de chargement commune est un charge du type Cherry-Hooper.

9. Le déphaseur selon les revendications précédentes, où l'étage de retard fixé ayant une seule paire différentielle de transistors est couplée entre deux étages de retard adjacentes.

10. Une méthode de faire marcher le déphaseur selon les revendications précédentes, la méthode comprenant le réglage sélectif des sources des courants variables d'une pluralité d'étages de retard, de façon que seulement les paires adjacentes des étages de retard sont activées, ainsi déterminant continuellement le retard du déphaseur partout l'étendue de dépassement.
